(19) Europäisches Patentamt
European Patent Office
Office européen des brevets

(11) **EP 4 755 545 A1**

(12) **EUROPEAN PATENT APPLICATION**

(43) Date of publication:
**10.06.2026 Bulletin 2026/24**

(21) Application number: **25167125.1**

(22) Date of filing: **28.03.2025**

(51) International Patent Classification (IPC):
**B22C 9/06** *(2006.01)*  **B22D 11/055** *(2006.01)*
**B22D 11/22** *(2006.01)*  **B22D 15/00** *(2006.01)*
**B22D 17/22** *(2006.01)*  **B22D 30/00** *(2006.01)*

(52) Cooperative Patent Classification (CPC):
**B22C 9/065; B22D 11/055; B22D 11/22;**
**B22D 15/00; B22D 17/2218; B22D 30/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.12.2024 PL 45049524**

(71) Applicant: **Akademia Górniczo-Hutnicza im.
Stanislawa Staszica
w Krakowie
30-059 Kraków (PL)**

(72) Inventors:
• **KOPYCINSKI, Dariusz**
  **32-444 Glogoczów (PL)**
• **PACZKOWSKI, Pawel**
  **30-383 Kraków (PL)**
• **WOJCIECHOWSKI, Krzysztof**
  **32-082 Kraków (PL)**

(74) Representative: **Wlasienko, Jozef et al
Polservice
Kancelaria Rzecznikow
Patentowych sp. z o.o.
Bobrowiecka 8
00-728 Warszawa (PL)**

(54) **METHOD AND SYSTEM FOR CONTROLLING CRYSTALLIZATION OF A CASTING**

(57) The invention relates to a method of controlling crystallization of a casting by actively receiving heat from the cooling casting by means of a chill (3) and a water cooler (5) through which water flows, the method comprising simulating the course of changes in a reference temperature parameter as a function of time for a desired microstructure of the casting, measuring the actual temperature parameter of the casting, comparing the value of the measured temperature parameter with the value of the reference temperature parameter in a given unit of time, adjusting the flow rate of water through the water cooler depending on the difference between the value of the measured temperature parameter and the value of the reference temperature parameter so that the course of changes in the value of the measured temperature parameter as a function of time corresponds to the course of changes in the value of the reference temperature parameter as a function of time. The temperature difference ($\Delta T$) of the chill (3) and the water cooler (5) is used as the temperature parameter, and a thermoelectric generator (4), the hot side of which is the chill (3) and the cold side of which is the water cooler (5), is used to measure the temperature difference ($\Delta T$).

The invention also relates to a system for controlling crystallization of a casting comprising a cooling unit with a water cooler (5) equipped with a water chamber, a cooling water tank (8) connected by means of a supply pipe (7) and a return pipe (6) to the water chamber of the water cooler (5), a pump (9) connected to the supply pipe (7) for forcing the water flow between the chamber of the water cooler (5) and the cooling water tank (8), and a controller (12) electrically connected to the pump (9), wherein the cooling unit further comprises a chill (3) adapted to contact the casting and a thermoelectric generator (4) provided between the chill (3) and the water cooler (5) and electrically connected to the controller (12).

**Fig. 2**

EP 4 755 545 A1

**Description**

The invention relates to a method and a system for controlling crystallization of a casting, especially in sand molds.

In foundry technology, chills are known, which are used to accelerate solidification in hot spots. Chills are metal inserts placed in a casting mold. In the standard solution, a chill is a metal object, which is characterized by greater conductivity and heat capacity than the molding mass, placed in a casting mold. The scope of the chill's operation is subject to limitation: after heating and equalization of the temperature between the casting and the chill, it ceases to fulfill its function. For this reason, use of the chill itself is a passive method of cooling the casting.

In order to maintain heat exchange between the casting and the chill, casting molds equipped with water chambers constituting the coolers are used, which are connected to external water sources so that the water flow through the cooler and continuous heat removal from the casting is ensured. This enables acceleration of the cooling of the casting and as a result, obtaining a specific internal structure of the casting, and this is an active method of cooling the casting.

An example of a sand mold with active cooling is disclosed in the publication CN220636282U. The box-shaped mold has an upper and lower part, which, when combined together, form an internal space for the sand and the casting. Holders are formed on the outside of the mold, into which cooling plates are inserted, which are adjacent to the walls of the mold. Pipes, in which water flows to remove the heat penetrating through the sand and the walls of the mold, are provided in the cooling plates.

An example of a sand mold with active cooling is also disclosed in the publication CN217095557U.

Heat removed from the casting can be dissipated to the environment in external coolers that receive heated water drained from the cooler, however, the background art knows methods of recovering such waste heat, including use of thermoelectric generators.

An example of active cooling of a casting in a mold with heat recovery by using a thermoelectric generator was disclosed in the publication CN115846629A. In the discussed solution, the casting mold is equipped with a water cooling chamber having a water inlet and outlet, with a valve placed on the water outlet. The solution comprises a sensor of the temperature parameter, which is the temperature of the water in the cooling chamber, and a thermoelectric generator, the hot side of which is in contact with the mold, and the cold side is washed with water. Cooling in such a system consists in supplying water to the cooling chamber in order to receive heat from the casting, measuring the water temperature, and opening the valve in order to allow water to flow through the cooling chamber, i.e. discharging heated water and supplying cool water, to reach the specific water temperature in the chamber.

Similar solutions using active water cooling of the casting and recovery of heat from the cooling using a thermoelectric generator were described in the publications CN215144480U and CN214557231U. For such use, thermoelectric generators generate electrical energy that can be stored in a battery or directly fed into the power grid. This constitutes recovery of the waste thermal energy with direct transformation into the electrical energy. The energy recovery compensates to some extent for the energy expenditure needed to melt the alloy first and thus increases energy efficiency of the casting process.

The known solutions for active cooling systems can accelerate the cooling of castings, and thus the process of obtaining elements from castings, but they do not provide sufficiently precise control of cooling the casting as well, and thus obtaining its specific internal structure in accordance with the set parameters.

Moreover, the cooling systems known from the prior art are permanently connected with a specific casting mold or simply constitute its integral part, which requires production of a separate mold for a specific purpose, increasing the costs associated with the production and storage.

A method of controlling crystallization of a casting, according to the invention, by actively receiving heat from a cooling casting by means of a chill and a water cooler through which water flows, the method comprising simulating the course of changes in a reference temperature parameter as a function of time for a desired microstructure of the casting, measuring the actual temperature parameter of the casting, comparing the value of the measured temperature parameter with the value of the reference temperature parameter in a given unit of time, adjusting the water flow rate through the water cooler depending on the difference between the value of the measured temperature parameter and the value of the reference temperature parameter so that the course of changes in the value of the measured temperature parameter as a function of time corresponds to the course of changes in the value of the reference temperature parameter as a function of time, characterized in that the temperature difference of the chill and the water cooler is used as the temperature parameter, a thermoelectric generator, the hot side of which is the chill and the cold side of which is the water cooler, being used to measure the temperature difference

Preferably, the temperature difference value is determined on the basis of the value of the current voltage supplied from the thermoelectric generator.

A system for controlling crystallization of a casting, according to the invention, comprising a cooling unit with a water cooler equipped with a water chamber, a cooling water tank connected by means of a supply pipe and a return pipe to the water chamber of the water cooler connected to a supply pipe of a pump for forcing water flow between the water cooler chamber and the cooling water tank, a controller electrically connected to the pump, characterized in that the cooling unit comprises a chill adapted to contact the casting and a thermoelectric generator located between the chill and the water cooler and electrically connected to the controller.

Preferably, the thermoelectric generator is permanently connected to the chill and the water cooler so that the cooling unit constitutes one element attached removably to the casting mold.

Preferably, the pump is located in the cooling water tank.

The advantage of the method according to the invention is precise control of the cooling process of the casting, resulting in obtaining a specific microstructure of the casting, wherein the production of a given casting is preceded by simulating the solidification process in commercial software, determining the time course of the parameter constituting the temperature difference between the chill and the water cooler and, consequently, repeatably controlling crystallization of the casting, and thus obtaining a repeatable microstructure of the produced castings.

In addition, the use of a thermoelectric generator as a temperature sensor eliminates the need to use additional elements, such as separate sensors, to control the casting cooling temperature. Thus, the use of a thermoelectric generator according to the invention performs simultaneously two functions - production of the energy from the waste heat of the casting process and direct measurement of the temperature parameter necessary for precise control of the casting cooling process.

The thermoelectric generator used in the cooling process can also act as a heating element when it is advisable to slow down cooling of the casting at a given stage.

The advantage of the system for controlling crystallization of a casting according to the invention is that, in relation to the casting mold, the cooling unit is a separate element which can further assume various shapes and sizes of the chill and can be used to cool various areas of the casting to provide their appropriate microstructure.

Moreover, several systems can be used to control the crystallization of the casting according to the invention in one mold, for cooling several different areas of the casting or for cascade cooling. In the case of castings with complex geometry, two or more chills may be used. Each chill at the simulation stage has its own time course of the parameter representing the temperature difference between the chill and the water cooler, and ultimately the influence of each chill allows for obtaining the desired temperature distribution in the solidifying casting. Each chill has its own course of the parameter representing the temperature difference between the chill and the water cooler as a function of time, and has its own controller. In such a case, the individual systems for controlling the crystallization of the casting are treated as independent systems.

The subject-matter of the invention is illustrated in the drawing, wherein Fig. 1 shows a diagram of an embodiment of a system for controlling crystallization of a casting according to the invention, Fig. 2 - a schematic representation of the arrangement of several systems for controlling crystallization of a casting according to the invention, in relation to the casting in a casting mold, Fig. 3 - a graph of the voltage-current relationship of the thermoelectric generator, Fig. 4 - a graph of the required maximum temperature difference $\Delta T_{MAX}$ for a given parameter of the interphase distance in the eutectic $\lambda$ for the ZnAl alloy, Fig. 5 - graphs of the $\Delta T$ parameter courses in the time domain, Figs. 6 a) and b) - views of the casting microstructure, and Fig. 7 - a graph of the relationship of phase distances for different alloy cooling intensities.

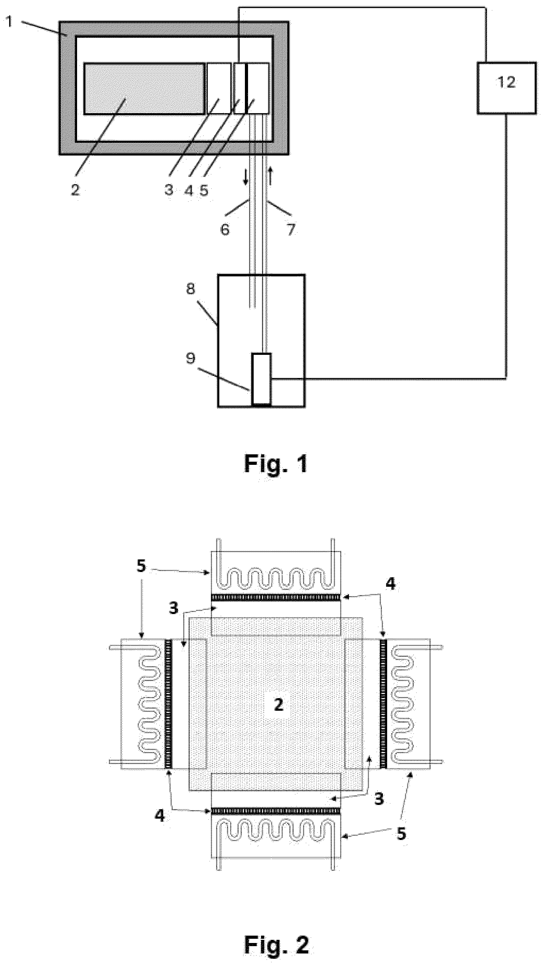

Fig. 1 shows a schematic representation of a sand casting mold 1 with a casting 2 placed therein and a system for controlling crystallization of the casting according to an embodiment of the present invention, which can also be referred to as an active cooling system. The system for controlling the crystallization of the casting comprises a cooling unit placed in the casting mold 1 and consisting of a chill 3, a water cooler 5 and a thermoelectric generator 4 arranged between them. The chill 3, the water cooler 5 and the thermoelectric generator 4 are permanently connected to each other, forming a cooling unit constituting one item attached removably to the casting mold 1.

The chill 3 is a solid metal element, at least one surface of which is in direct contact with the casting. The chill 3 has higher conductivity and thermal capacity than the molding mass filling the casting mold 1.

The water cooler 5 is a hollow element provided to create a water chamber, with two pipe connectors attached to it - a water supply connector and a water discharge connector.

The thermoelectric generator 4 of the embodiment is a generator with the symbol TEG1-241-1.4-1.2, which employs solid-state components made of bismuth telluride. The thermoelectric generator consists of solid-state (bar-shaped) components, that are connected in series. The cold and hot sides are insulated with ceramic plates. The symbol TEG1-241-1.4-1.2 of the generator means that the generator has a single layer (TEG1), consists of 241 pairs of PN junctions, a single N and P type semiconductor having a cross-section of 1.4 mm x 1.4 mm and a height of 1.2 mm. The generator is square-shaped with a side length of 55 mm and a thickness of 3.4 mm. The rated power of the generator (at a temperature difference of 150 °C) is 7 W, and the thermal conductivity is 2.18 W/(m·°C).

The mechanical connection of the thermoelectric generator 4 with the hot and cold sides is essential for efficient heat exchange, therefore the thermoelectric generator 4 is mechanically attached by means of a high thermal conductivity thermal adhesive to the suitably prepared contact surfaces of the chill 3 and the water cooler 5. The thermal adhesive ensures a permanent mechanical connection and good thermal conductivity by filling the irregularities at the contact area between the thermoelectric generator 4 and the chill 3 and the water cooler 5.

By means of connectors, the water chamber of the water cooler 5 is connected via a supply pipe 7 and a return pipe 6 to a cooling-water tank 8. In the tank, a pump 9 is arranged and connected to the supply pipe 7, in order to pump water into the water chamber of the water cooler 5.

The control system for crystallization of a casting also comprises a controller 12 which is electrically connected to the thermoelectric generator 4 and the pump 9, so that the controller 12 can control the operation of the pump 9 and adjust the water flow rate through the water chamber of the water cooler 5, as well as receive the current generated by the thermoelectric generator 4 and, for example, send it to an energy storage device (not shown) to use the stored energy to power the controller 12 and the pump 9 themselves.

In the described system for controlling crystallization of a casting according to the invention, the hot side of the thermoelectric generator 4 is the chill 3, while the cold side of the thermoelectric generator 4 is the water cooler 5. Thus, the generation of energy by the thermoelectric generator 4 occurs as a result of the temperature difference of the chill 3, i.e. *de facto* the casting itself, with which the chill 3 is in direct contact, and the water in the water cooler 5. The aforementioned temperature difference, denoted $\Delta$T, determines the heat flux flowing through the thermoelectric generator 4, and consequently the cooling intensity of the chill 3. The voltage generated by the thermoelectric generator 4 is directly proportional to the temperature difference between the hot and cold sides and is described by the relationship:

$$U = \alpha \, (T_2 - T_1) \qquad\qquad [1]$$

where U is the voltage generated by the thermoelectric generator 4 expressed in volts, $\alpha$ is the Seebeck coefficient, and $T_2$ - $T_1$ represent the temperature difference between the hot and cold sides of the generator, i.e. the $\Delta$T mentioned previously.

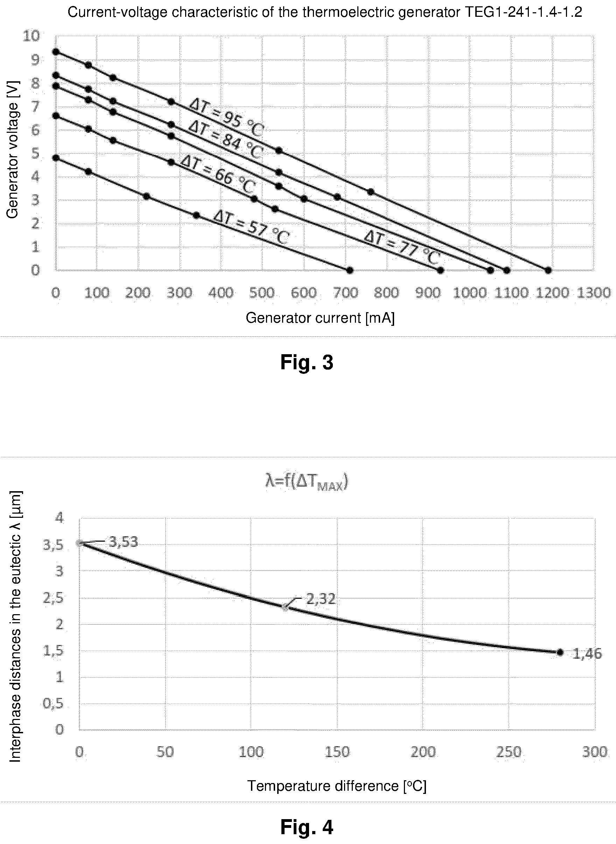

According to the Formula [1], the voltage generated by the thermoelectric generator 4 is directly proportional to the temperature difference $\Delta$T, as also shown in Fig. 3, which illustrates a family of characteristics describing the voltage U generated by the thermoelectric generator 4 used at different values of the temperature difference $\Delta$T as a function of the load current (for different values of load resistors). As can be seen in Fig. 3, the dependencies are linear, and therefore, in a simple way, using a linear function, the temperature difference $\Delta$T of the hot and cold sides can be determined based only on the measurement of the voltage U generated by the thermoelectric generator 4.

In view of the above, in the system for controlling crystallization of a casting according to the invention, the thermoelectric generator 4 may not only constitute an energy source using the waste energy of the casting process, but also a sensor of the temperature difference $\Delta$T.

There is a relationship between the course of changes in the temperature difference $\Delta$T over time during the cooling process of the casting and the obtained casting microstructure defined by the parameter of the average interphase distances $\lambda$. An example of this relationship is presented in Fig. 4, which shows the function of the interphase distance parameter $\lambda$ in the eutectic *versus* the maximum temperature difference $\Delta T_{MAX}$ for the ZnAl alloy. The function, the time course of which is shown in Fig. 4, was determined on the basis of the interpolation formula using the results obtained in experimental studies:

$$\lambda = A_1 \cdot \Delta T_{MAX}^2 + B_1 \cdot \Delta T_{MAX} + C_1 \qquad\qquad [2]$$

where $A_1$, $B_1$ and $C_1$ are polynomial interpolation coefficients, where

$$\lambda = \frac{113}{6720000} \cdot \Delta T_{MAX}^2 + \frac{2033}{168000} \cdot \Delta T_{MAX} + \frac{353}{100} \qquad\qquad [3]$$

where $\Delta T_{MAX}$ - [°C], $\lambda$ - [$\mu$m]

It follows from this that by appropriately selecting the value of the maximum temperature difference $\Delta T_{MAX}$ for a given alloy and adjusting the value of the temperature difference $\Delta$T during cooling of the casting, it is possible to precisely control the casting microstructure obtained.

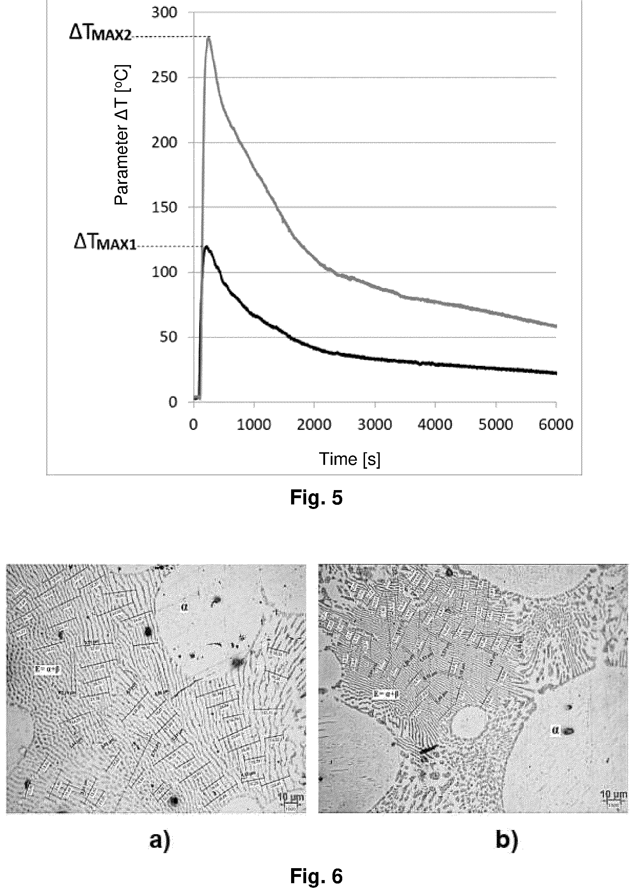

Fig. 5 shows two exemplary graphs showing the course of changes in the temperature difference $\Delta$T as a function of time during cooling of the casting for the ZnAl4Cu1 casting alloy. After pouring liquid metal into the mold, the temperature of the chill 3 increases rapidly, resulting in an increase of the temperature difference between the chill 3 and the water cooler 5 until the maximum temperature difference $\Delta T_{MAX}$ is reached, after which the casting starts to cool and the temperature difference $\Delta$T decreases. Importantly, the maximum value of the temperature difference $\Delta$T depends on the cooling intensity, i.e. the flow rate $q$ of the cooling water through the water chamber of the water cooler 5.

Each of the time courses of the temperature difference $\Delta$T shown in the graph of Fig. 5 is characterized by a different value of the maximum temperature difference $\Delta T_{MAX}$, $\Delta T_{MAX1}$ and $\Delta T_{MAX2}$, respectively. For each of the time courses of values of the temperature difference $\Delta$T shown, a different casting microstructure was obtained, shown in Fig.

6a) (for $\Delta T_{MAX1}$ = 125 °C at $q$ = 0) and in Fig. 6b) (for $\Delta T_{MAX2}$ = 275 °C at $q$ = 0.18 m$^3$/h), respectively. In order to illustrate the differences better, the features of the microstructures shown in Figs. 6a) and 6b) are included in the tables below:

| Microstructure of the casting of Fig. 6a) ($\Delta T_{MAX1}$ = 125 °C at q=0) | | |
|---|---|---|
| n = | 50 | |
| $\lambda_{MIN}$ = | 2.54 | [μm] |
| $\lambda_{MAX}$ = | 5.38 | [μm] |
| $\lambda_{SR}$ = | 3.33 | [μm] |
| σ = | 0.57 | [μm] |

| Microstructure of the casting of Fig. 6b) ($\Delta T_{MAX2}$ =275 °C at q=0.18 m$^3$/h) | | |
|---|---|---|
| n = | 50 | |
| $\lambda_{MIN}$ = | 1.13 | [μm] |
| $\lambda_{MAX}$ = | 2.22 | [μm] |
| $\lambda_{SR}$ = | 1.46 | [μm] |
| σ = | 0.21 | [μm] |

where *n* is the number of measurements and $\sigma$ is the standard deviation. The individual measurements are presented in Figures 6a) and 6b).

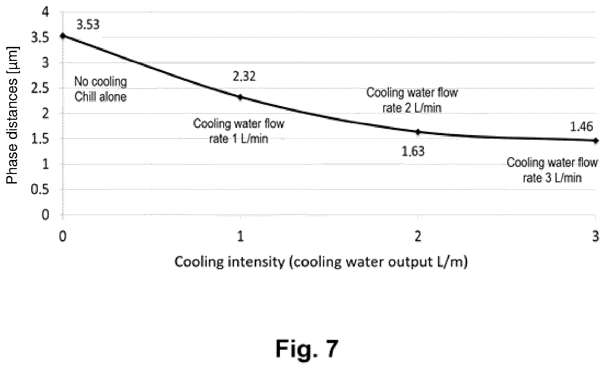

Figure 7 shows an exemplary relationship between phase distances $\lambda$ and different cooling intensities of the alloy mentioned above, which demonstrates that increasing the cooling intensity, and thus increasing the value of the temperature difference $\Delta T$, leads to obtaining shorter phase distances, and thus different physical properties of the casting.

The method of controlling the crystallization of a casting according to the invention generally relates to controlling the flow rate $q$ of water through the water chamber of the water cooler 5 in order to obtain an appropriate value of the maximum temperature difference $\Delta T_{max}$ and the course of changes in the temperature difference $\Delta T$ values as a function of time during cooling of the casting.

In order to determine the desired microstructure that is to be obtained for a given casting, a computer simulation of the casting process is carried out, for example in programs such as MAGMASOFT or ProCAST, which allows for representing actual conditions of casting processes. During the simulation, the casting mold and individual elements of the system for controlling crystallization of a casting are modeled in a program for simulating the casting processes, and then on this basis the temperature distribution during solidification of the casting is determined, which allows for determining the temperature difference $\Delta T$ values in the time domain. As a result of the simulation, the time course of $\Delta T(t)$ is obtained for a specific, desired casting structure.

Having at its disposal the reference time course of $\Delta T(t)$, the controller 12 adjusts the cooling intensity, i.e. controls the flow rate $q$ of the cooling water supplied by the pump 9, to the set time course of the temperature difference $\Delta T$ (as obtained from the simulation) in the actual casting during the cooling process.

The controller 12 divides the operation of the thermoelectric generator 4 into two modes: as an energy source and as a temperature sensor (by measuring the voltage generated by the thermoelectric generator 4). The controller 12 measures periodically the voltage value of the thermoelectric generator 4, converts this value to the measured temperature difference $\Delta T_{MEASURED}$ and relates the measured value to the reference value of the temperature difference $\Delta T_{SET}$ obtained from the simulation. By changing the cooling intensity, the controller 12 tends towards reaching a time course of the temperature difference $\Delta T$ obtained from the measurements that is consistent with the reference time course.

An exemplary configuration of the control system for crystallization of a casting, which enables collection and storage of electrical energy generated by the thermoelectric generator 4 and measurement of the voltage U on the thermoelectric generator 4 in order to determine of the temperature difference $\Delta T$ value, includes using a switching system (not shown) in the controller 12, which cyclically switches the thermoelectric generator 4 between the energy collection circuit (controllers for tracking the maximum power point that can be obtained from the generator, i.e. MPPT - Maximum Power Point Tracker) and the voltage value U measurement circuit for determining the value of the temperature difference $\Delta T$. The switching system is a part of the controller 12 and constitutes an additional functionality of the controller - and due to this, the controller 12 enables the recovery of waste heat and at the same time measurement of the actual value of the temperature difference $\Delta T$. An example of such a controller 12 may be a freely programmable logic controller enabling the implementation of such a solution.

In order to use the greatest possible amount of energy produced by the thermoelectric generator 4, for example, switching to the measuring circuit may take about 1% of the operating time, i.e. assuming the standard frequency of temperature measurements in the foundry industry of 1 second, it is possible to implement a system which uses the thermodynamic generator 4 as a source of electrical energy for 99% of the operating time, i.e. 990 ms, and 1% of the operating time, i.e. 10 ms, is used to measure the voltage U, i.e., after conversion, the value of the temperature difference $\Delta T$.

An exemplary process of controlling the crystallization of a casting 2 in a sand casting mold 1, using the method and system according to the invention, begins with the preparation of a casting mold 1. The said casting mold 1 is filled with a molding mass, e.g. sand, and one or more cooling units are arranged (each cooling unit being an element of a separate system for controlling the crystallization of the casting and connected to a separate controller 12 of the corresponding system) so that their chills 3 constitute at least a part of the walls of the forming cavity for the casting 2, as shown in Figures 1 and 2. Then, the course of changes in the reference temperature difference value $\Delta T_{SET}$ as a function of time, previously obtained by simulation, for the appropriate desired microstructure in a given area of the casting 2 adjacent to a given cooling unit, is entered into the controller 12 of each system for controlling the crystallization of the casting. After filling the molding cavity with the casting 2, the controller 12 of each system for controlling crystallization of the casting measures the voltage U of the thermoelectric generator 4 connected to it, which is converted into the value of the measured temperature difference $\Delta T_{MEASURED}$ in the cooling unit, which is then compared with the reference value of the reference temperature difference $\Delta T_{SET}$ at a given moment of time. Depending on whether the value of the measured temperature difference $\Delta T_{MEASURED}$ is greater or less than the reference value of the temperature difference $\Delta T_{SET}$, the controller 12 activates the pump 9 to increase or decrease the flow rate $q$ of water through the water chamber of the water cooler 5. As a result, the water flow through the water cooler 5 is varying. The controller 12 operates here as a regulator that controls the output of the pump 9 (the flow rate q) in such a way that the time course of the temperature difference $\Delta T$ value in the casting 2 is the same as the time course of the reference temperature difference $\Delta T_{SET}$ value determined earlier in the simulation.

In the case that it is required to maintain the temperature difference $\Delta T$ at a given level for a longer time or to extend the cooling process by reducing the drop in the temperature difference $\Delta T$ over time, the thermoelectric generator 4 can be powered from the controller 12, which in this case is equipped with an energy storage device (not shown) or connected to an external power source. In such a configuration, the thermoelectric generator 4 acts as a heater and supplies heat to the cooling tank 3, preventing the casting 2 from cooling down too rapidly.

**Claims**

1. A method of controlling crystallization of a casting by actively receiving heat from the cooling casting by means of a chill and a water cooler through which water flows, wherein the method comprises simulating the course of changes in a reference temperature parameter as a function of time for a desired microstructure of the casting, measuring the actual temperature parameter of the casting, comparing the value of the measured temperature parameter with the value of the reference temperature parameter in a given unit of time, adjusting the water flow rate through the water cooler depending on the difference between the value of the measured temperature parameter and the value of the reference temperature parameter so that the course of changes in the value of the measured temperature parameter as a function of time corresponds to the course of changes in the value of the reference temperature parameter as a function of time, **characterized in that** the temperature difference ($\Delta T$) of the chill (3) and the water cooler (5) is used as the temperature parameter, and a thermoelectric generator (4), the hot side of which is the chill (3) and the cold side of which is the water cooler (5), is used to measure the temperature difference ($\Delta T$).

2. The method according to claim 1, **characterized in that** the value of the temperature difference ($\Delta T$) is determined on the basis of the value of the voltage (U) of the current supplied from the thermoelectric generator (4).

3. A system for controlling crystallization of a casting, comprising:

   - a cooling unit with a water cooler (5) equipped with a water chamber,
   - a cooling water tank (8) connected by means of a supply pipe (7) and a return pipe (6) to the water chamber of the water cooler (5),
   - a pump (9) connected to the supply pipe (7) for forcing the water flow between the water cooler chamber (5) and the cooling water tank (8),
   - a controller (12) electrically connected to the pump (9),

   **characterized in that** the cooling unit comprises a chill (3) adapted to contact the casting and a thermoelectric generator (4) located between the chill (3) and the water cooler (5) and electrically connected to the controller (12).

4. A system according to claim 3, **characterized in that** the thermoelectric generator (4) is permanently connected to the chill (3) and the water cooler (5) so that the cooling unit constitutes one element attached removably to the casting mold.

5. A system according to claim 3, **characterized in that** the pump (9) is located in the cooling water tank (8).

**Fig. 1**

**Fig. 2**

Current-voltage characteristic of the thermoelectric generator TEG1-241-1.4-1.2

**Fig. 3**

$\lambda=f(\Delta T_{MAX})$

**Fig. 4**

Fig. 5

a)                                                         b)

Fig. 6

Fig. 7

| | Europäisches Patentamt European Patent Office Office européen des brevets | **EUROPEAN SEARCH REPORT** | **Application Number** EP 25 16 7125 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 7 575259 B2 (TOYOTA MOTOR CORP; MEC INT KK) 29 October 2024 (2024-10-29) | 3-5 | INV. B22C9/06 |
| A | * Machine Translation; paragraph [0030] - paragraph [0042]; figure 6 * | 1,2 | B22D11/055 B22D11/22 B22D15/00 B22D17/22 |
| A | US 2012/273019 A1 (SEIDEL JUERGEN [DE] ET AL) 1 November 2012 (2012-11-01) * paragraph [0094] - paragraph [0124]; figures 1-6 * | 1-5 | B22D30/00 |
| A | WO 2024/226504 A2 (ANDERSON EXPRESS INC [US]) 31 October 2024 (2024-10-31) * paragraph [0077]; figure 15 * | 1-5 | |

TECHNICAL FIELDS SEARCHED (IPC)

B22C
B22D

The present search report has been drawn up for all claims

| Place of search | Date of completion of the search | Examiner |
|---|---|---|
| The Hague | 28 August 2025 | Desvignes, Rémi |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 7125

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2025

| Patent document cited in search report | | Publication date | Patent family member(s) | | Publication date |
|---|---|---|---|---|---|
| JP 7575259 | B2 | 29-10-2024 | JP | 7575259 B2 | 29-10-2024 |
| | | | JP | 2022094455 A | 27-06-2022 |
| US 2012273019 | A1 | 01-11-2012 | AR | 078816 A1 | 07-12-2011 |
| | | | CN | 102667336 A | 12-09-2012 |
| | | | DE | 102010036188 A1 | 05-05-2011 |
| | | | EP | 2494272 A2 | 05-09-2012 |
| | | | TW | 201139942 A | 16-11-2011 |
| | | | US | 2012273019 A1 | 01-11-2012 |
| | | | WO | 2011051220 A2 | 05-05-2011 |
| WO 2024226504 | A2 | 31-10-2024 | NONE | | |

EPO FORM P0459

For more details about this annex : see Official Journal of the European Patent Office, No. 12/82

**REFERENCES CITED IN THE DESCRIPTION**

**Patent documents cited in the description**

- CN 220636282 U
- CN 217095557 U
- CN 115846629 A
- CN 215144480 U
- CN 214557231 U